(19) Europäisches Patentamt
European Patent Office
Office européen des brevets

(11) **EP 3 486 960 A1**

(12) **EUROPEAN PATENT APPLICATION**

(43) Date of publication:
**22.05.2019 Bulletin 2019/21**

(51) Int Cl.:
**H01L 51/46** *(2006.01)*

(21) Application number: **17202649.4**

(22) Date of filing: **20.11.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicants:
• **Universidad De Córdoba**
  **14005 Córdoba (ES)**
• **ECOLE POLYTECHNIQUE FEDERALE DE LAUSANNE (EPFL)**
  **1015 Lausanne (CH)**

(72) Inventors:
• **JODLOWSKI, Alexander Zachary Davis**
  **14014 Córdoba (ES)**

• **ROLDAN CARMONA, Cristina**
  **14014 Córdoba (ES)**
• **DE MIGUEL ROJAS, Gustavo**
  **14014 Córdoba (ES)**
• **CAMACHO DELGADO, Luis**
  **14014 Córdoba (ES)**
• **NAZEERUDDIN, Mohammad Khaja**
  **1024 Ecublens (CH)**

(74) Representative: **Schneiter, Sorin et al**
**Omnis IP SA**
**Ch. de Champ-Colomb 7 B**
**1024 Ecublens (VD) (CH)**

Remarks:
Claim 16 is deemed to be abandoned due to non-payment of the claims fee (Rule 45(3) EPC).

(54) **OPTOELECTRONIC DEVICE COMPRISING GUANIDINIUM IN THE ORGANIC-INORGANIC PEROVSKITE**

(57) Organic-inorganic lead halide perovskites have shown impressive power conversion efficiency (PCE) in a range of solar cell architectures. Despite the multiple ionic compositions that have been reported so far, the presence of organic constituents is an essential element in all the high efficiency formulations, with the methylammonium (MA) and formamidinium (FA) cations being the sole realistic options available to date. In this study, we demonstrate a novel three-dimensional (3D) perovskite with improved material stability as a result of the incorporation of an alternative organic cation, guanidinium, into the $MAPbI_3$ crystal structure. The new $MA_{1-x}Gua_xPbI_3$ perovskite shows enhanced thermal stability and intrinsically new structural and optoelectronic properties. This allows for stable and high-power conversion efficiencies over 20%, a fundamental step within the perovskite field.

**Figure 1f**

EP 3 486 960 A1

**Description**

**Technical Field**

The present invention relates to optoelectronic devices, such as solar cells, comprising an organic inorganic perovskite. The present invention further relates to the use of guanidinium as an organic cation in such perovskites and to a method for producing the perovskite and/or the optoelectronic device.

**Background Art and Problems Solved by the Invention**

Organic-inorganic perovskites have recently emerged as outstanding materials for a new generation of disruptive efficient and low-cost solar technology standing close to other photovoltaic (PV) alternatives such as silicon solar cells. Unique properties, including high absorption coefficient[1], large charge carrier diffusion lengths[2], small exciton binding energy[3] and low trap density[4], pushed their performances to an impressive record efficiency of more than 22 %. The most common perovskite structure arranges into $APbX_3$, ($A$ = $CH_3NH_3^+$ (MA) or $CH_3(NH_2)_2^+$ (FA); $X$ =Cl⁻, Br⁻ or I⁻) which crystalizes in a three-dimensional (3D) network ensuring an adequate charge transport within the material[3]. Among different candidates, optimized mixed ionic compositions of MA/FA cations[5] and Br⁻/I⁻ halides have recently led to superior performance, with a record in efficiency close to 21% for $(FAPbI_3)_{0.85}(MAPbBr_3)_{0.15}$ formulation[6]. Nevertheless, the impressive power conversion efficiency (PCE) progression of perovskite materials unfortunately confronts with serious stability concerns, due to an intrinsic decomposition to the initial precursors[7], which compromises their potentiality as a future market technology. Furthermore, mixed $(FAPbI_3)_{0.85}(MAPbBr_3)_{0.15}$ perovskite also suffers from intrinsic halide segregation[8, 9], with ambiguous long-term consequences. To overcome the stability issue, few strategies have been proposed[10-12], including the use of low-dimensional perovskites with enhanced thermal and chemical stability[13]. Yet, their limited efficiency below 13 % represents a persistent caveat for high-efficiency requirements. All at once, an exhaustive exploration of inorganic cations to stabilize the crystal structure has also been performed. Recent reports have shown promising results with the introduction of Cs⁺ and Rb⁺ mixtures into the hybrid $(FAPbI_3)_{0.85}(MAPbBr_3)_{0.15}$ structure, leading to a complex triple[14] and quadruple[15] composition that keeps the efficiency over 20%. Nevertheless, alternatives for the organic counterparts are so far non-available, restricting the existing high-performance formulations to the use of MA and FA cations. This is due to on one side the small number of candidates that, with a proper ionic radius ($R$), can fit into the inorganic $[PbI_6]^{-4}$ framework, while maintaining an adequate Goldschmidt tolerance factor

$$(t = R_A + R_I/\sqrt{2}(R_{Pb} + R_I),$$ between 0.8 - 1) that ensures a cubic structure[16, 17]. On the other side, theoretical investigations have indicated possible alternatives, including hydrazinium $[H_3N-NH_2]^+$ or azetidinium $[(CH_2)_3NH_2]^+$ cations[17], however to obtain good perovskite films has been experimentally challenging, and no successful results have been reported so far.

It is an objective of the present invention to improve stability, in particular thermal stability of optoelectronic devices comprising organic-inorganic perovskites while keeping or increasing conversion efficiency, such as the power conversion efficiency in case of a photovoltaic cell.

**Summary of the Invention**

Remarkably, the present inventors provide a mixed organic cation perovskite material comprising guanidinium. Surprisingly, the mixed organic cation perovskite has a 3D structure. Surprisingly, solar cell containing the perovskite exhibit increased stability and exceptionally high power conversion efficiency. These results are surprising, due to the cationic radius of the molecule, which is above the limit that is predicted to allow the formation of a cubic crystal structure.

In an aspect, the present invention provides an organic-inorganic perovskite comprising a guanidinium cation.

In an aspect, the present invention provides an optoelectronic device comprising an organic-inorganic perovskite comprising one, two or more organic cations, one of said two or more organic cations being guanidinium.

In an aspect, the present invention provides an organic-inorganic perovskite comprising two or more organic cations, one of said two or more organic cations being guanidinium.

In an aspect, the present invention provides a method for preparing an organic-inorganic perovskite comprising guanidinium.

In an aspect, the present invention provides a method for preparing an optoelectronic device comprising: depositing a layer of an organic-inorganic perovskite comprising guanidinium.

In an aspect, the present invention provides a method for preparing an optoelectronic device comprising:

depositing a layer of an organic-inorganic perovskite comprising guanidinium, wherein said organic-inorganic perovskite layer is deposited by depositing a solution comprising all constituents of the organic-inorganic perovskite, preferably in a single step deposition process, and/or by sublimation.

In an aspect, the present invention provides the use of guanidinium in an optoelectronic device, for example a solar cell, in particular in the organic-inorganic perovskite layer of said optoelectronic device.

In an aspect, the present invention provides the use of guanidinium for preparing an optoelectronic device, for example a solar cell, in particular in the preparation of the organic-inorganic perovskite layer of said optoelectronic device.

Further aspects and preferred embodiments of the invention are defined herein below and in the appended claims.

Further features and advantages of the invention will become apparent to the skilled person from the description of the preferred embodiments given below. These embodiments are provided by way of examples and the present invention is not intended to be limited to the particular embodiments.

## Brief Description of the Drawings

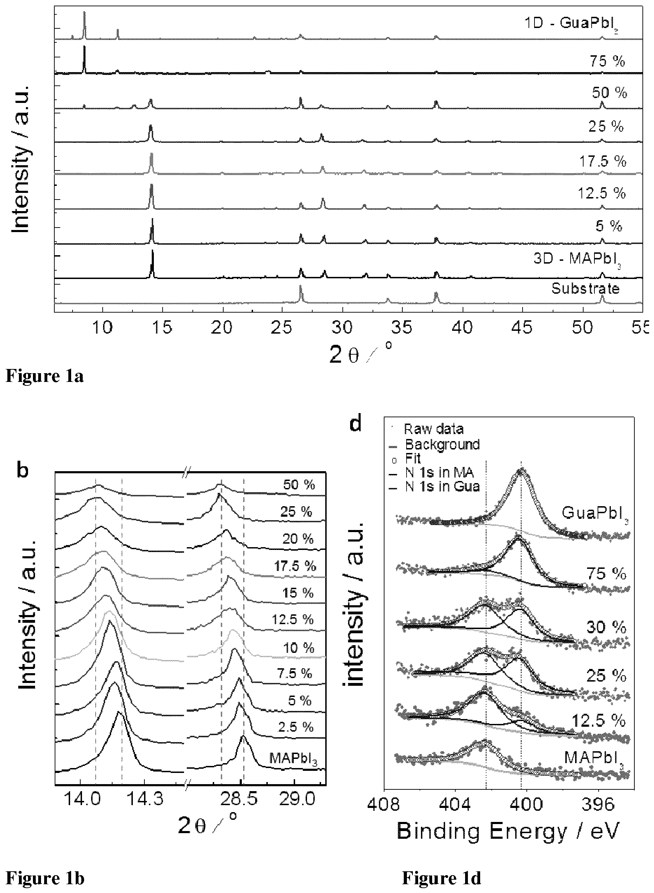

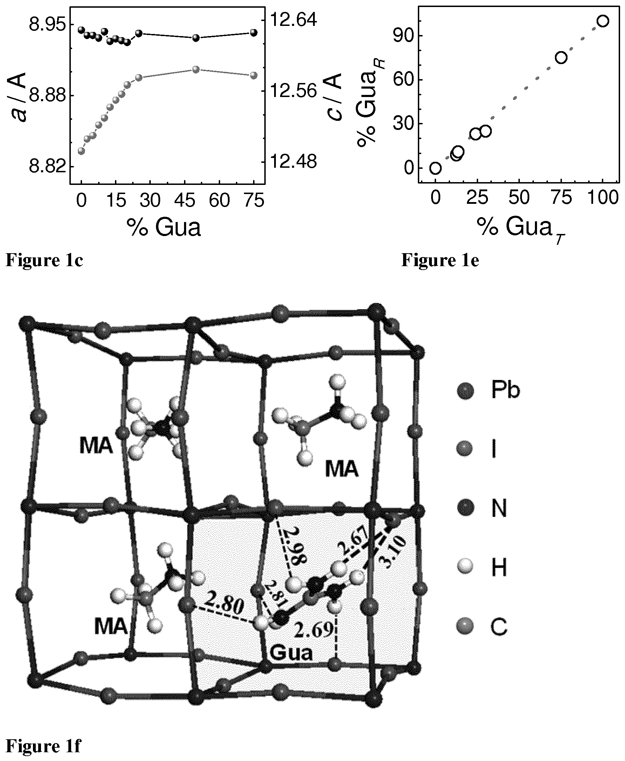

**Figures 1a - If:** XRD and XPS characterization of Gua-perovskites of embodiments of the invention. **Figure 1a,** Normalized XRD data of the mixed MA:Gua perovskite films containing several % of Gua. **Figure 1b,** Magnification of the XRD peaks at (220) *(left)* and (440) *(right)* upon variation of the Gua content (indicated in %). **Figure 1c,** Lattice parameters variation (*a* and *c*) of the $MA_{1-x}Gua_xPbI_3$ unit cell obtained from the crystallographic analysis of the experimental XRD patterns. **Figure 1d,** XPS spectra of N 1s for thin films of typical $MA_{1-x}Gua_xPbI_3$ perovskite mixtures (x = 0, 12.5, 25, 30, 50, 100). **Figure 1e,** Quantification of Gua % obtained from the XPS analysis (*Gua$_r$*, corresponds to the measured values; *Gua$_t$*, to theoretical values, initially incorporated to the precursor solution).

**Figure If,** Optimized simulated structure of the unit cell of $Ma_{0.75}Gua_{0.25}PbI_3$ including the six H- bond distances respect to I atoms.

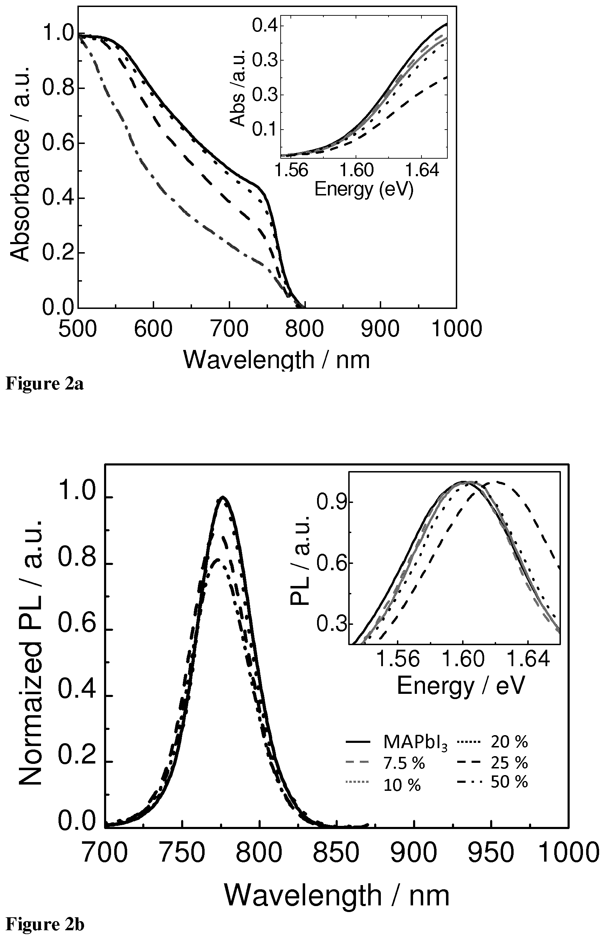

**Figures 2a-2c:** UPS and optical characterization of an embodiment. **Figure 1a,** UV-vis-NIR absorption spectra of typical $MA_{1-x}Gua_xPbI_3$ films containing x ≤ 0.5 shown in Fig.1 and magnification of the band edge (inset) for mixed films containing x ≤ 0.25 of Gua *(inset)*. **Figure 1b,** Photoluminescence (PL) spectra of the perovskite films shown in (a). **Figure 1c,** (*Left*) secondary electron cut-offs (SECO) for work function determination, *(center)* large and *(right)* short range binding energy range valence band spectra of the samples with different Gua:MA ratio.

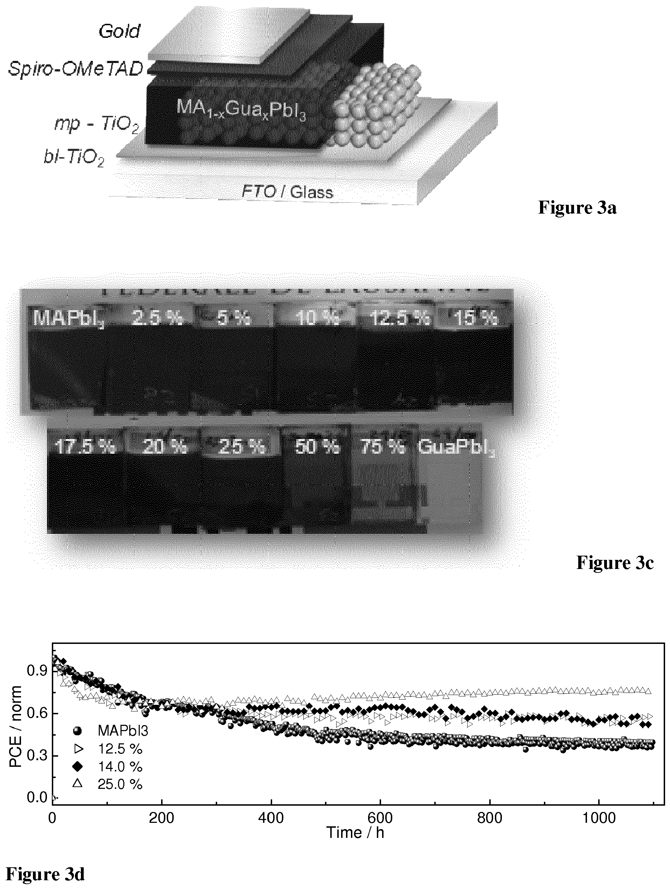

**Figures 3a-3f:** Device architecture, photographs, photovoltaic performance, and thermal stability test of Gua-perovskite devices according to an embodiment. **Figure 1a,** Device architecture of the perovskite solar cell incorporating Gua cations (Glass/FTO/c-TiO$_2$/mp-TiO$_2$/Perovskite/Spiro-OMeTAD/Au). **Figure 1b,** Plots of $J_{sc}$, $V_{oc}$, FF and PCE as a function of *x* in $MA_{1-x}Gua_xPbI_3$ systems. The data are averaged values obtained from more than 190 devices, where the highest and lowest values for each parameter are also indicated. **Figure 1c,** Photographs of the MA:Gua mixed perovskite devices containing increased % of Gua, indicated in the labels. **Figure 1d,** *J-V* curve and **Figure 1e,** *EQE* spectrum of the champion cell prepared with mixed MA:Gua perovskite containing 14% of Gua. **Figure If,** Thermal stability test of $MA_{1-x}Gua_xPbI_3$ perovskite solar cells (x = 0, 0.125, 0.15, 0.25) at 60 °C under continuous light illumination and MPP tracking in argon atmosphere. The initial PCE for each cell was 18,77%, 18.97 %, 18.11 %, and 17.14 % respectively.

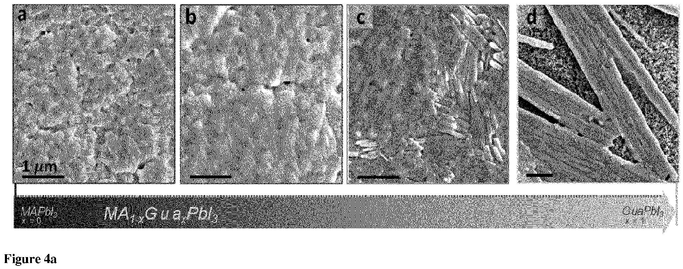

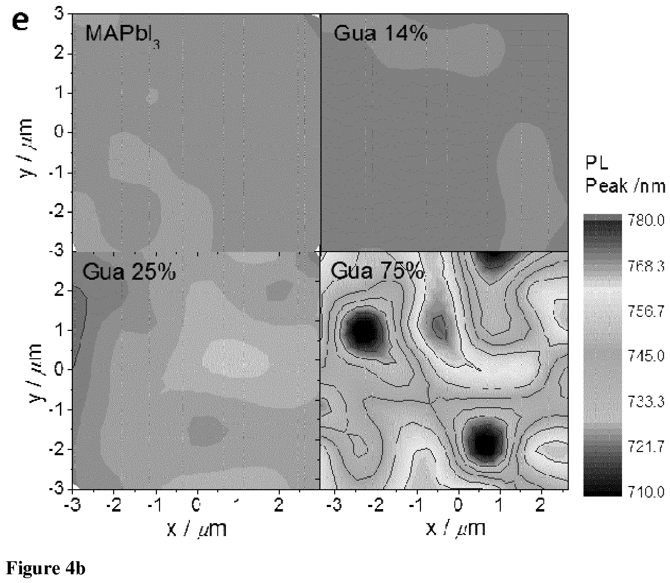

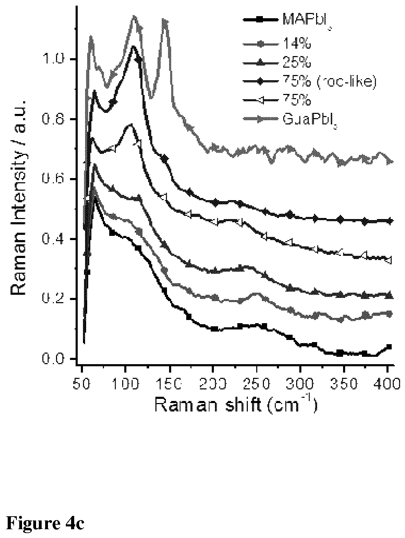

**Figure 4a-4c:** Morphology and phase segregation analysis according to an embodiment. **Figure 4a,** Top-surface SEM images of four representative samples, including pure MAPbI$_3$ and GuaPbI$_3$ phases, and mixed $MA_{1-x}Gua_xPbI_3$ system before and after phase segregation. **Figure 4b,** Micro-PL peak shift map and **Figure 4c,** micro-Raman spectra of the perovskite surface obtained for Gua contents equal to 0, 15, 25 and 75 %. The scalebar indicates the PL peak position in nanometers.

## Detailed Description of the Preferred Embodiments

The invention is related to an organic-inorganic perovskite comprising guanidinium. The invention is also related to optoelectronic devices comprising said perovskite.

For the purpose of the present specification, reference to "perovskite" refers to an organic-inorganic perovskite.

For the purpose of the present specification, the expression "comprising" and its grammatical forms are intended to mean "includes, amongst other". It is not intended to mean "consists only of".

In an embodiment, the organic-inorganic perovskite is and/or comprises a 3D (three-dimensional) perovskite and/or comprises a 3D crystal structure. Preferably, 1D perovskites are substantially absent from the perovskite. One surprising finding of the invention is that such perovskites can form 3D structures, although the size of the guanidinium cation would suggest that primarily 1D perovskites are formed. The 3D structure of perovskites may be determined by way of X-ray diffraction (XRD) measurement and/or by X-ray photoelectron spectroscopy (XPS), for example, and additional experiments as set out in the examples herein below. Preferably, the 3D perovskite is of the $AMX_3$ crystal type, as known from the specific perovskite mineral $CaTiO_3$ (see explanations in WO2014/180780, see also exemplary Fig. 1f for illustration only).

In an embodiment, the perovskite comprises one, two, three or four organic cations, including said guanidinium cation.

In an embodiment, the perovskite comprises guanidinium and an inorganic cation selected from Group 1 of the periodic table, preferably from $Cs^+$, $Rb^+$, and $K^+$. In an embodiment, the organic-inorganic perovskite comprises guanidinium and one or more additional organic cations. In yet another embodiment, the perovskite comprises guanidinium, one or more additional monovalent organic cations and one or more inorganic cations selected from group 1 of the periodic table.

In an embodiment, the perovskite comprises a metal cation, preferably a bivalent metal cation, carrying thus two positive charges. In an embodiment, said metal cation is selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$. In a preferred embodiment, said metal cation is selected from $Pd^{2+}$ and $Sn^{2+}$, preferably it is $Pd^{2+}$.

In an embodiment, the perovskite comprises one or more anions, preferably selected from monovalent anions. In an embodiment, said monovalent anions may be the same or different and are independently selected from $Cl^-$, $Br^-$, $I^-$, $NCS^-$, $CN^-$, and $NCO^-$. In a preferred embodiment, said anions are the same or different and are independently selected from halogen, more preferably from $Cl^-$, $Br^-$, $I^-$, most preferably from $Br^-$ and $I^-$.

In an embodiment, the perovskite comprises one, two or three organic cations in addition to said guanidinium cation. Preferably, the perovskite comprises two organic cations, guanidinium and another organic cation, such as methyl ammonium, for example.

Preferably, said organic-inorganic perovskite is a mixed organic cation perovskite. The invention includes mixed anion perovskites and single anion perovskites.

In an embodiment, wherein said guanidinium provides > 0 mol.% and ≤ 50mol.% of the organic cations in said organic-inorganic perovskite, preferably > 0 mol.% and ≤ 30mol.%, more preferably ≥ 5 mol.% and ≤ 30mol.%, and most preferably ≥ 10 mol.% and ≤ 25mol.% guanidinium. Accordingly, the remaining percentage up to 100mol.% is preferably provided by one or more other organic cations.

In an embodiment, said perovskite further comprises metal cations and anions, said anions being preferably selected from one or more halogens.

In an embodiment, said perovskite has a formula selected from formula (I)-(IV) below:

$$G_X [C]_Y [M] [A]_4 \qquad (I)$$

$$G_X [C]_Z [M] [A]_3 \qquad (II)$$

$$G_X [C]_Z [N] [A]_4 \qquad (III)$$

$$G_X [B]_Y [M] [A]_4 \qquad (IV)$$

wherein,

G is guanidinium cation;

[C] is selected from one or several different organic, monovalent cations, which may be the same or different and which are selected independently from primary, secondary, tertiary or quaternary organic ammonium compounds, including N-containing heterorings and ring systems, said organic monovalent cation having from 1 to 10 carbons and 1 to 10 heteroatoms, wherein [C] may also be selected, independently, from cations of elements of Group 1 of the periodic table;

[B] is one or several different organic, bivalent cations selected from primary, secondary, tertiary or quaternary organic ammonium compounds having from 1 to 15 carbons and 2 to 15 heteroatoms and having two positively charged nitrogen atoms;

[M] and [N] are one or several different metal cations,

[A] are one or several different anions,

X, Y and Z are selected so that:

$$X + Z = 1,$$

$$X + Y = 2,$$

$$0 < X \leq 0.5.$$

Preferably, with respect to formulae (I)-(IV), $X \leq 0.3$, most preferably $\leq 0.25$. Preferably, X is $\geq 0.01$, more preferably $\geq 0.03$, even more preferably $\geq 0.05$, and most preferably $X \geq 0.1$. Preferably, $0.08 \leq X \leq 0.3$, for example $0.1 \leq X \leq 0.25$.

In an embodiment, $0 < X < 0.25$.

Preferably, [M] is one or several different bivalent (carrying +2 charge) metal cations, and [N] is one or several different trivalent (carrying +3 charge) metal cations.

In an embodiment of the formulae (I)-(IV), [M] is one or several different divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$;

[N] is selected from the group of $Bi^{3+}$ and $Sb^{3+}$; and

[A] are independently selected from $Cl^-$, $Br^-$, $I^-$, $NCS^-$, $CN^-$, and $NCO^-$, preferably halogen.

As becomes apparent from the above, [A] represents one or more anions of the perovskite as mentioned elsewhere in this specification. Most preferably, the anions are selected from $Cl^-$, $Br^-$, and $I^-$.

Preferaly, [C] is other than guanidinium.

In a preferred embodiment, said perovskite has formula (II) $G_X [C]_Z [M] [A]_3$.

Organic and inorganic cations other than guanidinium that may be used in organic-inorganic perovskites, such as those which may be selected for [C] and [B], have been disclosed previously and elsewhere in this specification. For example, organic cations disclosed in EP2850626B1, paragraphs [0014], [0032]-[0041] are expressly and entirely incorporated herein by reference. Furthermore, organic cations as disclosed in US2017/0162811, paragraphs [0070]-[0097] are expressly and entirely incorporated herein by reference. Such cations may be used in the preparation or organic-inorganic perovskites in accordance with the present invention.

In an embodiment, said perovskite comprises one or more selected from the group consisting of: methyl ammonium, formamidinium, (protonated) 5-amino valeric acid, hydrazinium $[H_3N-NH_2]^+$ and azetidinium $[(CH_2)_3NH_2]^+$, $Cs^+$, $Rb^+$, and $K^+$ the organic cations of formulae (V) and of formula (VI) and combinations comprising two or more of the aforementioned.

In a preferred embodiment, organic cations that are used in the organic-inorganic perovskite may be selected from cations of formula (V) below:

$$(R_1R_2R_3R_4)N^+ \qquad (V)$$

wherein $R_1$, $R_2$, $R_3$, and $R_4$ are independently selected from H and substituted or unsubstituted C1-C10 alkyl, alkenyl or alkynyl, or substituted or unsubstituted aryl. Preferably $R_1$, $R_2$, $R_3$, and $R_4$ are independently selected from H and substituted or unsubstituted C1-C5, preferably C1-C3 alkyl, and from substituted or unsubstituted aryl.

Preferably, in the compound of formula (V), at least one of $R_1$-$R_4$ is different from hydrogen, such that an organic cation is obtained.

Typically, said cation of formula (V) is methyl ammonium $(CH_3)NH_3^+$.

In an embodiment, the organic cation may further be selected, in addition to the cations of formula (V), from cations of formula (VI):

$$(R_5R_6N=CH-NR_7R_8)^+ \qquad (VI)$$

wherein $R_5$, $R_6$, $R_7$, and $R_8$ may be the same or different and are independently selected from H, methyl or ethyl, more preferably from H and methyl. For example, the organic cation of formula $H_2N=CH-NH_2)^+$ may be included in the perovskite.

In an embodiment, said organic-inorganic perovskite has a formula selected from formula (X) below:

$$G_X \, C^1{}_P \, C^2{}_Q \, C^3{}_R \, M \, A^1{}_2 \, A^2{}_X \, A^3{}_P \, A^4{}_Q \, A^5{}_R \qquad (X)$$

wherein,

M is a divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$,

$Ge^{2+}$, $Sn^{2+}$, $Pb^{2+}$, $Eu^{2+}$, or $Yb^{2+}$;

G is said guanidinium cation;

$C^1$, $C^2$, $C^3$, may be the same or different and are independently selected from monovalent organic, and inorganic cations, wherein said organic cations may be the same or different and may be selected independently from primary, secondary, tertiary or quaternary organic ammonium compounds, including N-containing heterorings and ring systems, said organic cations having preferably from 1 to 10 carbons and 1 to 10 heteroatoms, and wherein said inorganic cations may be the same or different and are independently selected from cations of group 1 of the periodic table, preferably from $Cs^+$, $Rb^+$, and $K^+$;

$A^1$, $A^2$, $A^3$, $A^4$, $A^5$ may be the same or different and are independently selected from $Cl^-$, $Br^-$, $I^-$, $NCS^-$, $CN^-$, and $NCO^-$; preferably halogen, more preferably $Cl^-$, $Br^-$, $I^-$.

X, P, Q R are selected so that:

$$0 < X \leq 0.5,$$

$$P > 0, Q \geq 0, R \geq 0,$$

and

$$X + P + Q + R \geqslant 1.$$

Preferably, $C^1$, $C^2$, $C^3$, if they are organic cations, may have from 1 to 6 carbons and 1 to 5 heteroatoms, more preferably 1 to 4 carbons and 1 to 4 heteroatoms. Embodiments and examples or organic cations are disclosed elsewhere in this specification (e.g. formulae (VI) and (VI)).

In a preferred embodiment, heteroatoms mentioned in the present specification are selected from O, N, P, S, Se, Te and halogen, more preferably from O, N, P, most preferably they are N.

Preferably, $C^1$, $C^2$, $C^3$, in as far as present, are other and/or different from guanidinium. This preferably also applies to the one or more cations [C].

Preferably, X + P + Q + R = 1.

Preferably, with respect to formulae (X), $X \leq 0.3$, most preferably $\leq 0.25$. Preferably, X is $\geq 0.01$, more preferably $\geq 0.03$, even more preferably $\geq 0.05$, and most preferably $X \geq 0.1$. Preferably, $0.08 \leq X \leq 0.3$, for example $0.1 \leq X \leq 0.25$.

In an embodiment, 0 < X < 0.25.

Preferably, the structure of formula (X) comprises one or two additional organic or inorganic cations such that R=0. More preferably, R and Q=0, and X+P=1.

In a preferred embodiment, said organic-inorganic perovskite has a formula selected from formula (XI) below:

$$G_X \, C^1_P \, M \, A^1_2 \, A^2_X \, A^3_P \qquad\qquad (XI)$$

wherein G, $C^1$, M, $A^1$, $A^2$, and $A^3$ are as defined above,

$$0 < X \leq 0.5,$$

$$P > 0,$$

and

$$X + P \geq 1. \text{ Preferably, X+P= 1. Preferably, } X \leq 0.3, \text{ most preferably} \leq 0.25.$$

In an embodiment, [C], $C^1$, $C^2$, $C^3$, which may be the same or different, are selected from organic cations as disclosed elsewhere in this specification, such as organic cations of formula (V) and/or (VI), for example. Furthermore, the anions are preferably selected from one or more halogens, preferably Br, I and or Cl, more preferably Br and I.

Preferred metals [M] or M are $Pb^{2+}$ and $Sn^{2+}$, for example in the perovskites of formulae (I)-(IV) and (X).

In an aspect, the invention provides an optoelectronic device. Exemplary devices are solar cells and light emitting diodes (LEDs), such as perovskite light emitting diodes (PLEDs), transistors and detectors. preferably, the optoelectronic device is a photovoltaic device. Preferably, the device is a perovskite solar cell.

Preferably, the optoelectronic comprises said organic-inorganic perovskite. For example, the perovskite may be provided in the form of a layer in said device, including a layer immersed in a porous layer, for example.

Preferably, the device comprises (i) a first electrode, and (ii) a second electrode, wherein said organic-inorganic perovskite is disposed between said first and second electrode. For example, said first and second electrodes may be in the form of an anode and a cathode, for example a photoanode and a counter electrode. Suitable electrode materials are known from the art and are disclosed in references cited in the present application. For example, in the Rong et al reference cited below, a carbon counter electrode/cathode was employed.

In an embodiment, the device further comprises one or more selected from an n-type layer and a p-type layer, disposed between said first and second electrode, said n- and/or p-type layer, in as far as present, preferably being in electric contact with said organic-inorganic perovskite.

Preferably, the n-type layer comprises an n-type semiconductor material and/or electron transport layer and the p-type layer comprises a p-type semiconductor and/or hole transport layer. The n-type layer is typically selected from metal oxide semiconductors and may or may not be nanoporous and/or mesoscopic. N-type layers are typically selected from organic and/or inorganic hole transport materials. In an embodiment the device comprises both, and n-type layer and said p-type layer. In some embodiments, only an n-type layer is present. Exemplary n- and p-type layers are well known in the art and are disclosed, for example, in EP2850626, EP3065189 and in WO2014/180780.

Preferably, the perovskite is disposed between said n- and p-type layers, or between one of said n- and p-type layers (if there is only one such layer) and an electrode for example. For example, a p-type layer is absent and the perovskite is provided between an n-type layer and an electrode, such as a counter electrode, for example.

Many different types of perovskite solar cells have been described, and the present invention is not limited to a particular device type or architecture. The invention also encompasses devices having an inverted architecture, for example as disclosed in EP 2846371. As another example, the invention encompasses devices as disclosed in Rong et al J. Phys. Chem. Lett. 2014, 5, 2160-2164, disclosing cells with the architecture FTO-glass/dense $TiO_2$/mesoscopic $TiO_2$/porous $ZrO_2$/Carbon, where the perovskite is infiltrated from solution through the porous carbon layer to fill in the voids in the mesoscopic $TiO_2$ and the porous $ZrO_2$ scaffold layer. These latter exemplary cells lack a hole transport layer.

The present invention provides a method for preparing an optoelectronic device and/or an organic-inorganic perovskite. Methods for depositing such perovskite layers have been described.

Such methods encompass so-called two-step depositions, in which the constituents of the perovskite to be obtained are deposited sequentially, one after the other, and so-called "single step" methods, where the constituents of the perovskite are all deposited in a single step or simultaneously.

EP2804232, for example, discloses a two-step deposition method from solution. In accordance with this method, a divalent or trivalent metal salt is deposited first, followed by the deposition of an organic ammonium salt in a solvent. This method may be adapted to the perovskite of the present invention.

For example, when the perovskite is deposited from a solvent, the constituents of the perovskite may be dissolved in an appropriate solvent, and are deposited together with removal of the solvent thereafter.

The present inventors observed that deposition in a single step may result in better device properties and/or perovskite structure. It is emphasized that the term "single-step" does not imply that the entire perovskite deposition including solvent removal is achieved in a single step. Rather, the term "single-step" indicates that all the constituents of the perovskite are provided in a single solution, and the perovskite is obtained by depositing this solution. The present inventors observed that when proceeding in such a manner, a 3D perovskite comprising the guanidinium cation was obtained. This is surprising, due to the comparatively large size of the guanidinium cation, which is normally expected not to fit into the crystal structure of a 3D perovskite. Therefore, perovskites containing guanidinium are generally 1D perovskites, as illustrated in Figure 4a, right side photograph, for example. The present inventors surprisingly report a 3D organic-inorganic perovskite comprising the guanidinium cation.

According to the method of the invention, the constituents of the perovskite are preferably dissolved in an appropriate solvent or solvent mixture. For example, the solvent may be selected from the group consisting of: gamma-butyrolactone (GBL), DMF, DMSO, isopropanol, acetonitrile, and mixtures comprising one, two or more of the aforementioned. The invention is preferably not limited to any particular solvent, but solvents or mixtures or solvents may be selected, for example with the goal of adjusting the viscosity of the solvent so as to optimize the suitability for the deposition.

When dissolving constituents of the perovskite in a suitable solvent, the halide (or other anions, as disclosed above) salts of the organic cations and halide (or other anions, as disclosed) salts of the metal (e.g. M, N) are preferably dissolved in the same solvent or solvent mixture. Alternatively, the salts are dissolved in (the same or different) solvents in separate recipients, followed by mixing the contents of the two recipients.

When dissolving the constituents in one or more solvents, some constituents may be added in excess, such that the final solution to be deposited does not necessarily have the exactly same stoichiometry as the perovskite that is obtained. For example, organic cation salts comprising templating agents, such as 5-amino valeric acid, may be added in excess. Generally, some organic cation salts may be added in excess, for example. This is why, in formula (X) above, it is said that $X + P + Q + R \geq 1$. The "larger than one"-part encompasses the situation where all constituents are dissolved in a solvent, and preferably not the situation of the final perovskite, the latter being expected to contain constituents in stoichiometric amounts, such that $X + P + Q + R = 1$. In this regard, in some embodiments, formula (X) refers to the constituents of the perovskite as dissolved in the solvent.

The perovskite may be deposited from the solution in any suitable manner, and the invention is not limited to a particular deposition process. For example, the perovskite may be deposited by spin-coating, but various additional methods are disclosed in the literature. For example, Anyi Mei et al Science 345, 295 (2014) disclose perovskite layer deposition by inkjet printing. Generally, the method comprises an annealing and/or heating step, where the deposited perovskite is exposed to above-room temperature (RT=25°C), for example to a temperature in the range of 40-100°C for a determined amount of time, in order to achieve complete evaporation of the solvent.

The perovskite may also be deposited by sublimation. For the purpose of the present specification, the expression "sublimation" means that this is the transition from the solid phase of a material (crystal, for example) to the gas phase of said material (or vapor phase) without passing through an intermediate liquid phase. Sublimation is favored and preferably occurs at very low pressure, such as high vacuum. It is possible to deposit constituents of the perovskite by codeposition or sequentially, similarly to the principles of deposition from solution. It is also possible to combine sublimation processes with deposition from solution, since it is possible to deposit the constituents of a perovskite sequentially. For the purpose of the present specification, deposition by "sublimation" includes processes such as physical vapor deposition methods group. The physical vapor deposition methods group encompasses cathodic arc deposition, electron beam physical vapor deposition, thermal evaporation, evaporative deposition, pulse laser deposition, and sputter deposition. The invention also encompasses combination of deposition from solution and sublimation, for example deposition of part of the constituents by sublimation and the remaining part by deposition from solution, or vice versa. Deposition processes such as sublimation are disclosed in European application with publication number EP 2846371.

Further features and advantages of the invention will become apparent to the skilled person from the description of the Examples below. These examples are provided by way of examples and the present invention is not intended to be limited to the particular examples. Theories and explanations presented in order to explain the surprising results are not intended to limit the scope of the appended claims.

## Examples

Here we introduce a novel, thermodynamically more stable and high efficient 3D perovskite material based on $CH_6N_3^+$, often known as guanidinium (Gua), as organic cation. Gua features a cationic radius of ~278 $\mu m$[17], slightly above the upper limit of tolerance factor (t ~1.03), thus forming low-dimensional perovskites in its pure form[18, 19]. However, we demonstrate that when combined with methylammonium in a mixed $MA_{1-x}Gua_xPbI_3$ formulation ($0 < x < 0.25$) the Gua inserts in the crystal unit, forming a 3D-perovskite structure with enhanced thermal and environmental stability. Our results suggest a paradigm shift in the material's design as further explorations beyond the tolerance factor limit could prevail for cationic blends while preserving its 3D structure and high photovoltaic performance. In our case, solar cells with high PCE beyond 20% and enhanced stability have been fabricated, a breakthrough within the perovskite field.

The novel $MA_{1-x}Gua_xPbI_3$ perovskite was prepared by mixing stoichiometric MAI, GuaI and $PbI_2$ precursors in N,N'-dimethylsulfoxide (DMSO) with MAI:GuaI gradually changing from 1:0 to 0:1, while keeping the $PbI_2$ molarity invariable. Uniform thin films were fabricated through a two-step spin-coated method, using chlorobenzene as antisolvent agent[20]. To get insight into the arrangement of the Gua cations in the $MA_{1-x}Gua_xPbI_3$ crystal structure, X-ray diffraction (XRD) measurement of the thin films were performed. **Figure 1a** shows the diffractogram pattern of the perovskite films containing MA:Gua mixtures varying from $0 > x > 1$ ($x$, being Gua molar ratio), on $TiO_2$-electrode as used for the PV devices. For comparison, the XRD pattern of the $MAPbI_3$ is also reported, where the reflection peaks characteristic of the 3D perovskite crystalizing in the tetragonal phase can be distinguished. The incorporation of Gua cations yields a gradual decrease of the reflection peak intensity, but retaining the tetragonal phase of $MAPbI_3$ even for 25% of addition. Larger percentages of Gua decrease significantly the signal, being almost indiscernible with 75%, while the appearance of new reflection peaks at 8.54° and 11.31° indicates the formation of the one-dimensional (1D) $GuaPbI_3$ phase, as shown in the experimental and simulated XRD pattern[21]. Interestingly, a closer inspection of the reflection peaks reveals a notable shift to lower angles. In **Figure 1b** a zoom of the diffraction peaks corresponding to the (110) and (220) lattice planes is shown. Upon increasing the Gua content a gradual shift of the peaks together with an enhanced broadening is observed. A similar shift in the reflection peaks of the $\alpha$-phase of $FAPbI_3$ has been recently assigned to the sequential substitution of the FA cation by Cs atoms to generate the mixed $Cs_xFA_{1-x}PbI_3$ perovskite[22]. In our case, this phenomenon denotes a sequential expansion of the unit cell volume, clearly indicating the incorporation of the larger Gua cation by direct substitution of MA into the perovskite lattice crystal, leading to a mixed $MA_{1-x}Gua_xPbI_3$ material. The lattice parameters, $a$ and $c$, obtained from the experimental XRD patterns are disclosed in **Figure 1c**. Note that the $c$ value persists almost constant for all percentages, 12.625 Å, while $a$ gradually changes from 8.838 Å to 8.902 Å, remaining invariable for Gua contents larger than 25%. These results are consistent with a distortion of the crystal prevalently affecting the *a* and *b* lattice parameters, which takes place for Gua additions below 25 %. Besides, due to the mismatch in size with respect to the MA cation, the incorporation of Gua entails local distortions in the crystal lattice, which manifest as a broadening of the peaks. Note that this effect cannot be readily interpreted as an increased number of detrimental defects. Each Gua cation can incorporate to the crystal in a slightly different configuration, producing distortions that are not perfectly regular in the network. Such local deformations are indeed an additional indication of the Gua incorporation to the lattice. To confirm our observations, we have evaluated the crystal strains in the structure by using the Williamson-Hall method. Results (not shown) demonstrate an increased number of micro-strains at larger percentages of Gua, confirming the distortions of $MAPbI_3$ lattice due to the Gua insertion. However, further increments do not incorporate to the crystalline network and therefore, remain probably as the 1D $GuaPbI_3$ crystal phase, leading to phase-segregated 1D/3D blends, as suggested by the XRD pattern. This is in contradiction to previous reports where Gua has been proposed as a passivating agent, which does not incorporate into the perovskite structure due to its larger size[23]. Nevertheless, in reported works Gua is usually incorporated by using the so-called two-step method, in which a thin $PbI_2$ film is immersed in a mixed cation solution, without an exhaustive control on the final composition. We believe that the significant variations in the perovskite preparation methods may account for the different crystallization dynamics and the role of components in the reported systems. In this study, we incorporate Gua already within the precursor solution, ensuring the desired stoichiometry after crystallization.

The relative composition and chemical environment of the constituents in the perovskite materials have been also analyzed by X-ray photoelectron spectroscopy (XPS). Measurements performed for the pure MA and Gua phases and four representative mixtures (12.5%, 25% 30% and 50% Gua) reveal the formation of Pb-I bonds and a relative Pb/I ratio of ~ 3.0, consistent with the theoretical stoichiometry present in the 3D $MA_{1-x}Gua_xPbI_3$ and 1D $GuaPbI_3$ structures. Additionally, the photoemission spectra of the N 1s region, reported in **Figure 1d,** reveal the two peaks attributed to the $NH_3^+$ group in MA (402.3 eV) and the $NH_2^+$ group in Gua (400.3 eV), which changes gradually in intensity upon increasing the Gua content. In particular, the relative area of both peaks confirms that the initial experimental MA/Gua ratio is preserved within the final structure, as presented in **Figure 1e** (and also corroborated by Nuclear Magnetic Resonance (NMR) measurements, not shown), which is particularly valuable in the determination of the crystalline structure.

To shed light on the role of Gua into the crystalline material, DFT-GGA calculations using the PBE exchange correlation functional were conducted, to examine the stability of the proposed $MA_{1-x}Gua_xPbI_3$ structures. An estimation of the formation enthalpies at zero temperature, $\Delta H_f$, for the pure MA and Gua phases, as well as for that containing 25% Gua was performed. A remarkable difference for the three perovskite structures was found, with a clear tendency when increasing the Gua content: $\Delta H_{f(MA\_pure)}$ = -0.149 eV >> $\Delta H_{f(MA0.75\_Gua0.25)}$ -1.484 eV > $\Delta H_{f(Gua\_pure)}$ -2.045 eV. Compared to the pure $MAPbI_3$ phase, which exhibits a close to zero value consistent with previous reports[24,25], 1D $GuaPbI_3$ points to enhanced stability, as expected for low-dimensional perovskites[26]. However, a striking result appears for the mixed $Ma_{0.75}Gua_{0.25}PbI_3$ perovskite, which also exhibits a highly negative formation enthalpy, close to that of the 1D $GuaPbI_3$, while maintaining its 3D structure. Note that such a behavior will have important implications in the solar cell performance, as the substitution of ¼ of MA by Gua in the $MAPbI_3$ structure entails a significant increase of the system stability. Besides, a phase separation of the $MA_{0.75}Gua_{0.25}PbI_3$ into the pure MA and Gua systems was found to be thermodynamically less favored ($\Delta H_f$ = -0.622 eV), and it is foreseen that it does not occur at lower percentage of Gua. Only at Gua fractions higher than 25%, both $Ma_{0.75}Gua_{0.25}PbI_3$ and $GuaPbI_3$ crystalline phases appear, given the impossibility of the 3D octahedral $[PbI_6]$ network to accommodate additional voluminous Gua cations. Such a behavior is in full agreement with our experimental XRD observations, and calls for deeper investigations towards its suitability as a novel photovoltaic alternative. **Figure If** shows the optimized structure of the unit cell for $Ma_{0.75}Gua_{0.25}PbI_3$, where the main H-I interactions with the Gua cation can be also identified. Note that the formation of hydrogen bonds plays a key role in the structural stabilization of the perovskite. Compared with the 1-2 H-bonds per MA molecule[27], the introduction of Gua substantially increases the number of interactions to six H-bonds while reducing the H - I distance, which seems to be the ultimate cause for the superior stability of the $Ma_{0.75}Gua_{0.25}PbI_3$ system. Importantly, our results suggest that the crystal distortions produced by the larger cation could be compensated at the expense of the neighboring cavities, where the small MA cation locates, preserving its 3D structure. This provides new insights in the design of hybrid perovskites and incentives the search of blends comprising cations with compatible sizes, placing also in the spotlight those slightly out of the tolerance factor limit. Furthermore, the effect of the lattice expansion on the optoelectronic properties was also analyzed by DFT-GGA calculations. The electronic band structures and density of states (DOS) for $MAPbI_3$ and two representative mixtures (12.5% and 25% Gua) show no appreciable difference (results not shown), with I 5p states mainly contributing to the top valence band and Pb 6p states dominating the lowest conduction band. Nevertheless, there is a small but gradual increase in the bandgap energy with the insertion of Gua, showing values equal to 1.77 eV, 1.79 eV and 1.82 eV for $MAPbI_3$, 12.5% and 25% of Gua respectively. The direct character of the $MAPbI_3$ bandgap is also conserved in the two mixtures, with the minimum bandgap occurring at the $\Gamma$ symmetry point. Moreover, the three samples display a similar dispersion of the valence and conduction bands, which ensures low carrier effective masses.

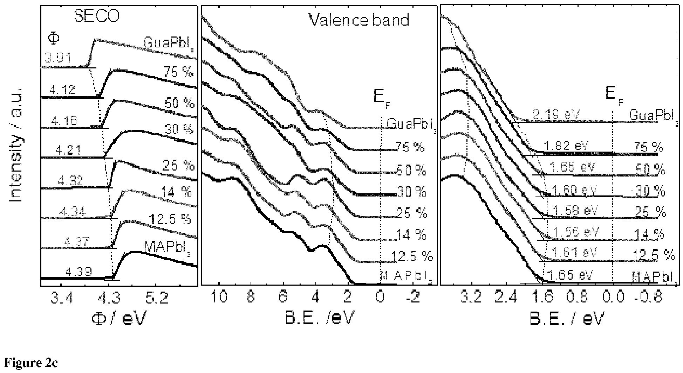

Consequently, along with the stabilization, the incorporation of Gua preserves the optical properties of the material. **Figure 2a** shows the normalized absorption spectra for four typical $Ma_{1-x}Gua_xPbI_3$ thin films with Gua content below 50 %. In agreement with the theoretical calculations, no significant changes in the shape of the spectrum are observed for mixtures containing Gua below 20 %, except a tiny but continuous shift in the absorption band edge, as illustrated in the inset of **Figure 2b.** Yet, Gua contents over 20% produce an appreciable lowering of the absorption capacity along with a blue-shift of the band edge (~0.02 eV), indicative of a widening of the band gap. This can be related to the different organic-inorganic interactions mediated by the new hydrogen bonds, which lead to local distortions at the Gua neighboring positions, and expand the crystal unit. Results for higher Gua percentages are also reported(not shown). A sharp band edge at ~ 500 nm, with a remarkable excitonic peak at 390 nm appears for pure 1D $GuaPbI_3$, as previously reported in literature[21]. This is also detected for fractions of Gua beyond 50 %, which, together with the reminiscence absorption band edge of $Ma_{0.75}Gua_{0.25}PbI_3$ at ~775 nm, confirms the preservation of both individual phases. Accordingly, the photoluminescence (PL) spectra acquired from the bulk films, shown in **Figure 2b,** manifest a gradual shift towards higher energy for samples containing less than 20 % Gua, as observed for the absorption onset (see inset Figure 2b), which becomes more apparent for 25 % Gua, and preserves for larger Gua amounts, consistent with the results observed in **Fig. 2a.** These findings provide compelling evidence that the substitution of MA by Gua efficiently stabilizes a 3D perovskite phase while retaining extended and efficient absorption similar to the $MAPbI_3$. In addition, the electronic structure was also investigated by ultraviolet photoelectron spectroscopy (UPS). The results reveal a slight but gradual shift of the valence band onset (by 0.04-0.09 eV) towards the Fermi level from $MAPbI_3$ to $MA_{1-x}Gua_xPbI_3$ samples containing up to 25 %, while retaining the main valence band features, as depicted in **Figure 2c.** Concomitantly, the ionization energy becomes slightly reduced (by up to 0.14 eV). However, a distinct impact to the system is detected for larger amounts of Gua (> 30%), resulting in a shift of the valence band onset away from the Fermi level, and a solid change in the valence band features, increasingly resembling those corresponding to pure $GuaPbI_3$ perovskite (binding energy region between 5.5 eV and 8.7 eV).

To demonstrate the applicability of Gua-containing perovskites, we implemented the newly developed material into standard mesoporous based solar cells, where the $Ma_{1-x}Gua_xPbI_3$ perovskite is sandwiched in between a mesoporous (mp)-$TiO_2$ electrode, used as electron transporting material (ETM), and 2,2',7,7'-tetrakis(N,N'-di-p-methoxyphenylamine)-9,9'-spirobifluorene (Spiro-OMeTAD) as the hole-transporting material (HTM). The device architecture is shown in Figure 3a. The photovoltaic parameters, listed in Table 1 below, are markedly affected by the Gua content.

**Table 1:** Photovoltaic parameters obtained for the best performing cells containing MA:Gua perovskite systems measured under AM1.5G sun illumination. In brackets are indicated the averaged values for each condition from more than 190 devices (scan rate: 0.01 V·s⁻¹; stabilization time: 5 s).

| % Gua | $J_{sc}$ (mA·cm⁻²) | $V_{oc}$ (V) | FF | PCE (%) |
|---|---|---|---|---|
| 0 | 22.50 (22.0±0.8) | 1.050 (1.04±0.02) | 0.80 (0.74 ± 0.04) | 18.88 (17 ± 1) |
| 2.50 | 22.28 (21.99±0.7) | 1.060 (1.058±0.009) | 0.76 (0.75 ± 0.04) | 18.14 (17 ± 1) |
| 5.00 | 22.49 (22±1) | 1.070 (1.054±0.01) | 0.782 (0.76 ± 0.02) | 18.81 (17 ± 1) |
| 7.50 | 22.49 (22.0±0.4) | 1.061 (1.05±0.01) | 0.786 (0.77 ± 0.03) | 18.75 (17.8±0.9) |
| 10.0 | 22.53 (22.3 ± 0.3) | 1.090 (1.07±0.02) | 0.777 (0.75 ± 0.03) | 19.09 (17.8±0.9) |
| 12.5 | 22.79 (22. ±0.5) | 1.094 (1.07 ± 0.02) | 0.785 (0.77 ± 0.03) | 19.58 (18.3±0.7) |
| 14.0 | 23.19 (22.8 ±0.3) | 1.082 (1.07 ± 0.01) | 0.803 (0.79 ± 0.01) | 20.15 (19.2±0.4) |
| 15.0 | 22.34 (22.3 ± 0.4) | 1.070 (1.07 ± 0.01) | 0.795 (0.77 ± 0.02) | 18.99 (18.4±0.4) |
| 17.0 | 22.54 (21.7 ± 0.5) | 1.091 (1.08 ± 0.02) | 0.785 (0.78 ± 0.02) | 19.29 (18.1±0.7) |
| 20.0 | 21.31 (21.3 ± 0.5) | 1.095 (1.08 ± 0.01) | 0.790 (0.77 ± 0.03) | 18.43 (17.7±0.8) |

(continued)

| % Gua | $J_{sc}$ (mA·cm$^{-2}$) | $V_{oc}$ (V) | FF | PCE (%) |
|---|---|---|---|---|
| 25.0 | 20.85 (20.6 ± 0.7) | 1.107 (1.09 ± 0.02) | 0.790 (0.77 ± 0.02) | 18.30 (17.1±0.8) |
| 50.0 | 12.79 (11 ± 2) | 1.080 (1.09 ± 0.03) | 0.667 (0.66 ± 0.02) | 9.21 (8±1) |
| 75.0 | 0.59 (0.56±0.08) | 0.920 (0.88 ± 0.04) | 0.600 (0.61 ± 0.04) | 0.33 (0.30±0.04) |
| 100 | 0.50 (0.3±0.3) | 0.857 (0.882 ± 1) | 0.394 (0.42 ± 0.04) | 0.17 (0.12±0.08) |

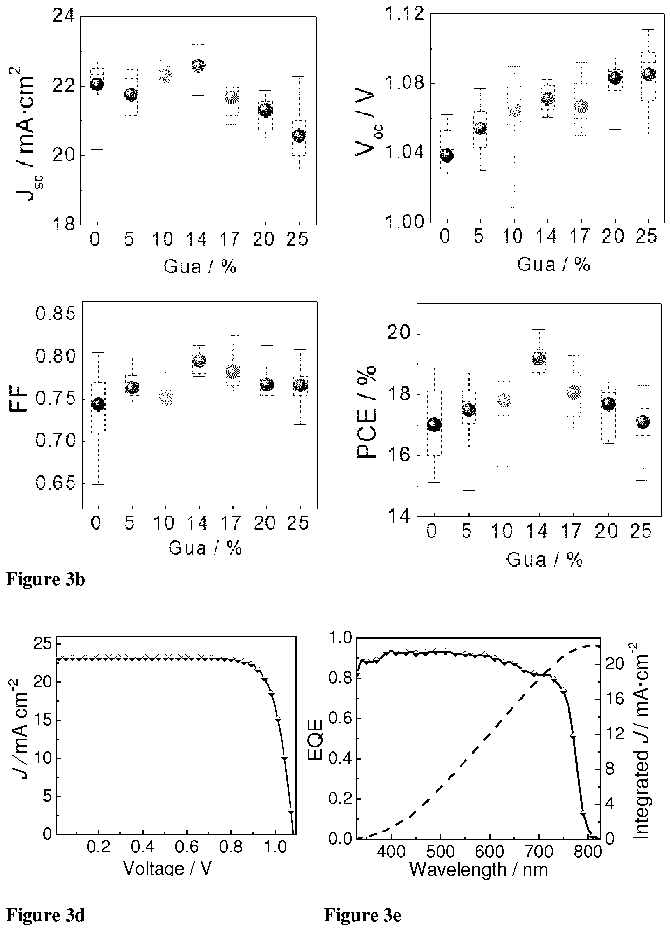

**Figure 3b** presents the average results obtained for more than 190 cells prepared with mixed $MA_{1-x}Gua_xPbI_3$ perovskite upon varying its relative content (0 > x > 0.25). As observed in the figure, the short circuit current density ($J_{sc}$) hardly changes for Gua fractions up to 20 %, but gradually lowers for increased Gua contents, with 14 % of Gua outstanding among the others. This behavior can be easily related with the decreased absorption detected when more than 20 % of Gua is incorporated, as supported by the external quantum efficiency (EQE) spectra (result not shown). In addition, the average open circuit voltage ($V_{oc}$) increases progressively with the incorporation of the Gua cation, from 1.04 V for x = 0 to 1.085 V for x = 0.25, as expected from the optical bandgap observations (see Fig. 2), with a maximum $V_{oc}$ value surpassing 1.1 V. Noteworthy, the fill factor (FF) remains almost unaltered, with high average values over 0.75 (and maxima close to 0.80 for high Gua contents). As a result, the average power conversion efficiency (PCE) of the prepared cells increases from 17.02 % for $MAPbI_3$ to 19.23% for the Gua/MA mixed system containing 14 % Gua, and a champion cell efficiency surpassing 20 %. Moreover, even for perovskites containing 25 % of Gua, the photovoltaic performance remains very similar to that of the pure $MAPbI_3$, with averaged PCE of 17.14 % and a record efficiency of 18.30 %. A photograph of the as prepared $MA_{1-x}Gua_xPbI_3$ solar cells increasingly incorporating Gua in the active layer is displayed in **Figure 3c.** The current density versus voltage (J - V) curve and EQE obtained for the champion device are presented in **Figure 3d** and **3e** respectively, showing a device efficiency as high as 20.15 %. Particularly, the EQE demonstrates high photon-to-current conversion over 80 % throughout the entire UV-visible spectrum, leading to an integrated current density of 22.09 mA·cm$^{-2}$, which is comparable to the state-of-the-art perovskite materials. Current-Voltage hysteresis measurements and maximum power point tracking (MPPT) were also conducted (results not shown).

The device stability has been tested under AM1.5G sun illumination at maximum power point (MPP) tracking. The perovskite solar cells have been aged for more than 1000 hours at 60 °C under continuous light illumination. The results are shown in **Figure 3f,** revealing an enhanced stability for higher Gua contents, providing experimental evidence of the beneficial effect of the material stability, as predicted by the theoretical calculations. As illustrated in the figure, despite the initial decrease, which has been recently associated to the inter-penetration of Spiro-OMeTAD and gold electrode[28], a gradual stabilization and recuperation of the performance is observed, which is reproducible and clearly correlated with the Gua content. In addition, we have performed an initial light stress tests at 85°C using polytriarylamine polymer (PTAA), a more stable HTM, under 300 hours of illumination, which further confirms the enhanced stability of mixed MA/Gua perovskite compared to $MAPbI_3$ (results not shown). We also analyzed the charge dynamics in the fabricated perovskite solar cells by electro-chemical impedance spectroscopy (EIS). These results suggest an increased recombination resistance and longer electron lifetime as we add Gua into the perovskite material, possibly related with a more efficient charge extraction and better crystal formation. Overall, these findings represent a paradigm shift within the perovskite field as for the first time, an alternative organic cation different from MA$^+$ and FA$^+$ comes into play, showing unforeseen results and a great potentiality for highly efficient and long-term stable solar cells. Furthermore, additional improvement can be expected from the optimization of the deposition methods and device architecture, as already experienced for the MA and FA based perovskites in the last few years.

To gain insight into the micro-structure and phase stability of the mixed MA/Gua system, we analyzed the film morphology and phase segregation of the perovskite by using scanning electron microscopy (SEM) and combined micro-Raman and micro-photoluminescence (micro-PL) spectroscopy. **Figure 4a** shows the SEM images obtained for four representative compositions, including the pure phases of $MAPbI_3$ and $GuaPbI_3$, as well as samples containing Gua below and above 25%, at which the phase segregation should occur. As presented in the figure, $MAPbI_3$ film has a grainy like morphology where large crystal domains with a diameter of around one micrometer can be easily distinguished (see black line). On the contrary, $GuaPbI_3$ presents a completely different morphology, with elongated rod-like crystals of several micrometers in length, typical for the 1D aggregation. Noteworthy, samples containing the Gua cation below 25% do not show any similar phase within the film while a uniform morphology is observed, resembling the $MAPbI_3$ but with a considerably increased size of the crystal domains, as emphasized by the orange line incorporated in the picture.

A prominent relation between the amount of Gua and the size of the crystal domains is also observed for all samples (results not shown), in which the domains remain like islands of several micrometers within the capping layer. The 1D-like morphology is only detected for samples containing higher amounts of Gua (> 25 %), as also appreciated in **Fig. 4,** at which phase segregation may occur.

These results, are also confirmed by the micro-Raman and micro-photoluminescence (micro-PL) analysis shown in **Figure 4b** and **4c.** Averaged over a diffraction-limited spot size of 300 nm, this technique can provide further information about local heterogeneities within the film[29]. Four different samples were investigated in terms of PL properties, with a particular focus on the distribution of the PL peak position. The PL peak position is intimately linked to the material band-gap, which changes with composition, as recently reported by few of us[8], or local disorder[30] over microscopic areas of the samples. **Figure 4b** shows the mapping of the PL peak position over 6x6 $\mu m^2$ regions of four representative samples. In the wavelength emission range between 710 nm and 780 nm, no appreciable change in the PL peak is observed for Gua content < 25%, remaining around 770 nm, as for the pure $MAPbI_3$. On the contrary, the addition of 75% Gua leads to the appearance of a contrasted PL map with regions extending up to few micrometers, with a remarkable PL shift down to 710 nm. This behavior gives evidence of the phase segregation occurring in the material, resulting in a distribution of different band gaps across the film. On the same areas, micro Raman spectra were recorded. Indicative spectra are reported in Figure 4c. For Gua contents up to 25% the Raman spectra closely resemble the one obtained for the pure $MAPbI_3$. Characteristic broad peaks in the region below 200 $cm^{-1}$ are observed related to the Pb-I stretching and bending modes[31, 32], along with a broad feature around 250 $cm^{-1}$ related to the vibrations of the organic cation. Remarkably, as recently observed when FA is incorporated in the $MAPbI_3$, a gradual shift of the peak to lower wavenumber appears, suggesting a shrinking of the mode due to the incorporation of the distinct Gua cation in the unit cell. For Gua content above 25% we could identify a position-dependent signal that changes in line with the PL variation. In particular, some regions show a similar spectrum as for the lower Gua content, while on the regions presenting the "rod-like" morphology, a remarkably different behavior is detected. In particular, a redistribution of the relative peak intensity happens with a dominant peak at 120 $cm^{-1}$ and the appearance of an additional peak at 135 $cm^{-1}$, both with a reduced broadening of the signal. This peak shift is usually attributed to the presence of isolated Pb-I planes, similarly to the case of $PbI_2$ intercalated with large organic molecules[33], which suggest the formation of a low dimensional perovskite. The analysis is corroborated by comparing the spectrum with that of the pure $GuaPbI_3$ arranging into the 1D phase. As observed in the Figure, it shows apparent peaks at 120 $cm^{-1}$ and 135 $cm^{-1}$ as previously asserted for the 75 % sample. These results further confirm the phase homogeneity of the mixed $MA_{1-x}Gua_xPbI_3$ for Gua < 25% which, on the contrary reveals a severe phase segregation into a 3D/1D mixture for larger Gua amounts, while retaining the individual features of the single constituents. Note that no visible degradation signs are observed upon the PL measurements (results not shown).

To summarize, we present a new perovskite composition based on a combination of Gua and MA cations which exhibits superior photovoltaic performance and material stability compared with the pure $MAPbI_3$. We demonstrate that the incorporation of large Gua cations unexpectedly forms a highly stable 3D crystalline structure, plausibly mediated by the increased number of H-bonds within the inorganic framework. The novel $MA_{1-x}Gua_xPbI_3$ perovskite preserved the good optoelectronic properties associated to organic lead halide materials, leading to high PCE surpassing 20 % for Gua content of 14 %. Our results emphasize the versatility of organic-inorganic lead halide perovskites, and invites to further explorations of organic cations including those that are beyond the limit of the tolerance factor.

## Methods

### Experimental.

*Solar cell fabrication.* Perovskite solar cells were fabricated on F-doped $SnO_2$ (NSG10) substrates previously cleaned by a sequential sonication treatment in a 2 % Hellmanex solution, acetone and isopropanol, followed by UV ozone treatment for 15 min. A compact blocking layer of $TiO_2$ (bl-$TiO_2$, 30 nm in thickness) was then deposited onto the FTO glass substrate by spray pyrolysis, using a titanium diisopropoxide bis(acetylacetonate) solution in ethanol (60% v/v), and then sinter at 450 °C for 30 minutes. A 200-nm thick layer of mesoporous $TiO_2$ (mp-$TiO_2$, 30 NR-D titania paste from Dyesol) was prepared by spin-coating a diluted $TiO_2$ dispersion in ethanol, ratio 1:8 by weight, at 2000 rpm for 15s followed by a sintering step at 500 °C for 30 min. Afterwards, the substrates were lithium-treated by spin-coating 40 $\mu l$ of tris(bis(trifluoromethylsulfonyl)imide) (Li-TFS) (14.67mg/ml in acetonitrile) onto the mesoporous layer, followed by a sintering step at 500 °C for 30 min. Stoichiometric precursor solutions were prepared by mixing MAI, GuaI (Dyesol) and $PbI_2$ (TCI) in N,N'-dimethylsulfoxide (DMSO) with MAI:GuaI gradually changing from 1:0 to 0:1, while keeping the $PbI_2$ molarity equal to 1.25. The perovskite layers were then fabricated by using a two-steps spin-coating process reported by Seok *et al.*[20] (first step 1,000 r.p.m. for 10s; second step 4,000 r.p.m for 30 s) and 15s prior to the end of the program 100 $\mu l$ of chlorobenzene were poured onto the films, and then substrates were annealed at 100 °C during 45 min. After this time, spiro-OMETAD was spin-coated at 4000rpm, 30s from a chlorobenzene solution (28.9mg in 400$\mu l$, 60mmol)

containing Li-TFSI (7.0$\mu$l from a 520mg/ml stock solution in acetonitrile), TBP (11.5$\mu$l) and Co(II)TFSI (10mol%, 8.8$\mu$l from a 40mg/ml stock solution) as dopants. Finally, a 70 nm gold electrode was evaporated.

*Thin film Characterization.* The XRD patterns of the prepared films were measured using a D8 Advance diffractometer from Bruker (Bragg-Brentano geometry, with an X-ray tube Cu K$\alpha$, $\lambda$=1.5406Å). The absorption spectra were registered with an UV-VIS-IR spectrophotometer (*PerkinElmer Instrument*). Photoluminescence (PL) steady-state measurements were recorded with a spectrophotometer (*Gilden Photonics*). The micro PL and micro Raman measurements were performed on a Renishaw InVia Raman microscope with an L100x objective (spot size of about 300 nm). The PL map was recorded using (0.0005% laser intensity, corresponding to 100uJ/cm$^2$) using a 532 nm green laser diode. The spectra were registered in the 710-820nm region. Raman spectra are obtained using the same excitation monitoring the 50 - 250 cm$^{-1}$ range, particularly sensitive to the Pb-I modes. The final data were averaged over 50 accumulations in order to maximize the signal to noise ratio. To prevent sample degradation or thermal effects the laser power intensity was kept below (excitation density of around 3mW/cm$^2$ (0.005%)) and the light exposure time per measurement was 0.1 seconds. Photoelectron spectroscopy (PES) measurements were performed in an ultra high vacuum system (base pressure of 2 x 10$^{-10}$ mbar) using a He-discharge UV source (Omicron) with an excitation energy of 21.2 eV for UPS and Al K$\alpha$ X-ray source (excitation energy: 1486.6 eV) for XPS. The photoelectron spectra were recorded using a Phoibos 100 (Specs) hemispherical energy analyzer at a pass energy of 5 eV for the valence band and a pass energy of 20 eV for the core levels. For work function determination, the secondary electron cut-off (SECO) was recorded by applying a -10 V sample bias to clear the analyzer work function. The reported valence band spectra were background subtracted. The binding energies for all the photoemission spectra are referenced to the Fermi level. For a comparison of the XPS core level spectra, the binding energy values were all adjusted to the C 1s carbon at lower binding energy that was here referenced to 285 eV. A mixed Gaussian/Lorentzian peak shape and a Shirley type background were employed for XPS peak fitting with the XPS Peak 4.1 software. Nuclear Magnetic Resonance (NMR) measurements were performed for samples containing % Gua up to 30. Mixed MA$_{1-x}$Gua$_x$PbI$_3$ perovskite films were prepared on conductive FTO-substrates in the same conditions as for the photovoltaic devices. Once the perovskite layers were crystalized, the solid films were re-dissolved in deuterated dimethyl-sulfoxide (DMSO-d6) and directly analyzed in liquid state $^1$H-NMR 800MHz instruments equipped with 5mm triple channel 1H/13C/15N cryoprobe and a AVII console. The method used was a single pulse with 16 scans, a delay of 5s and a pulse length of 7.8us.

*Device Characterization.*

The photovoltaic device performance was analyzed using a VeraSol LED solar simulator (Newport) producing 1 sun AM 1.5 (1000W/m$^2$) sunlight. Current-voltage curves were measured in air with a potentiostat (Keithley 2604). The light intensity was calibrated with a NREL certified KG5 filtered Si reference diode. The solar cells were masked with a metal aperture of 0.16 cm$^2$ to define the active area. The cells were measured in air, at room temperature and without encapsulation, at a constant rate 10 mV·s$^{-1}$ for both forward and reverse bias. No special preconditioning protocol was used apart from 5 seconds of stabilization time before the measurement. No anti-reflective coating was used during the measurement. The stability test was performed in a sealed cell holder flushed with a flow of argon (30 mL/min) and *I-V* curves were characterized by an electronic system using 22 bits delta-sigma analogic to digital converter. For *I-V* curves measurement, a scan rate of 25 mV/s with a step of 5 mV was used, maintaining the temperature of the cells around 60 °C. Cells were maintained at the maximum power point using a MPPT algorithm under 100mW/cm$^2$. A reference Si-photodiode was placed in the holder to verify the stability of the light. EQE was measured with the IQE200B (Oriel) without bias light.

*Computational calculations*

Geometrical structures of PbI$_2$[34], GuaI,[35], MAI [36,37], tetragonal MAPbI$_3$Ma[38], and 1D GuaPbI$_3$[21], from the bibliography, were optimized, without cell optimization. For the different perovskites, MA$_{1-x}$Gua$_x$,PbI$_3$ where x = 0, 0.25 and 1, only the organic material position was optimized, restrain the Pb and I position obtain from the diffractogram. We proceed in this way, because the MA geometric arrangement is not known in detail from the information obtained from the diffractograms[39, 40]. Periodic DFT-GGA calculations using the PBE exchange correlation functional were performed[41]. Electron-ion interactions were described by ultrasoft pseudopotentials. In case of the Pb atom we used a scalar relativistic pseudopotential. A 4x4x4 Monkhorst-Pack grid was chosen for sampling the Brillouin zone[42]. Given these compounds are essentially ionic in nature, electrostatic interactions well described by DFT-GGA are expected to represent the main contribution in the interaction. This is indirectly confirmed by the usually good agreement between experimental and calculated structural parameters for this type of materials[43].

**References**

1. De Wolf, S. et. al. Organometallic Halide Perovskites: Sharp Optical Absorption Edge and Its Relation to Photovoltaic Performance. Journal of Physical Chemistry Letters, 5, 1035-1039, (2014).

2. Stranks, S. D. et. al. Electron-Hole Diffusion Lengths Exceeding 1 Micrometer in an Organometal Trihalide Perovskite Absorber. Science, 342, 341-344, (2013).

3. Xing, G. et. al. Long-Range Balanced Electron- and Hole-Transport Lengths in Organic-Inorganic CH3NH3PbI3. Science 342, 344-347, (2013).

4. Shi, D et. al. Low trap-state density and long carrier diffusion in organolead trihalide perovskite single crystals. Science 347, 519-522, (2015).

5. Zhang, Y. et. al. Optimization of Stable Quasi-Cubic FAxMA1-xPbI3 Perovskite Structure for Solar Cells with Efficiency beyond 20%. ACS Energy Letters 2, 802-806, (2017).

6. Bi, D. et. al. Efficient luminescent solar cells based on tailored mixed-cation perovskites. Science Advances, 2, 1, (2016).

7. Conings, B et. al. Intrinsic Thermal Instability of Methylammonium Lead Trihalide Perovskite. Advanced Energy Materials 5, 1500477, (2015).

8. Gratia, P. et. al. Intrinsic Halide Segregation at Nanometer Scale Determines the High Efficiency of Mixed Cation/Mixed Halide Perovskite Solar Cells. Journal of the American Chemical Society 138, 15821-15824, (2016).

9. Hoke, E. T. et. al. Reversible photo-induced trap formation in mixed-halide hybrid perovskites for photovoltaics. Chemical Science 6, 613-617, (2015).

10. Li, X. et. al. Improved performance and stability of perovskite solar cells by crystal crosslinking with alkylphosphonic acid ω-ammonium chlorides. Nat Chem. 7, 703-711, (2015).

11. You, J. et. al. Improved air stability of perovskite solar cells via solution-processed metal oxide transport layers. Nat Nano 11, 75-81, (2016).

12. Kaltenbrunner, M. et. al. Flexible high power-per-weight perovskite solar cells with chromium oxide-metal contacts for improved stability in air. Nat Mater 14, 1032-1039, (2015).

13. Tsai, H. et. al. High-efficiency two-dimensional Ruddlesden-Popper perovskite solar cells. Nature 536, 312-316, (2016).

14. Saliba, M. et. al. Cesium-containing triple cation perovskite solar cells: improved stability, reproducibility and high efficiency. Energy & Environmental Science 9, 1989-1997, (2016).

15. Saliba, M. et. al. Incorporation of rubidium cations into perovskite solar cells improves photovoltaic performance. Science 354, 206-209, (2016).

16. Goldschmidt, V. M., Die Gesetze der Krystallochemie. Naturwissenschaften 14, 477-485, (1926).

17. Kieslich, G. et. al. Solid-state principles applied to organic-inorganic perovskites: new tricks for an old dog. Chemical Science 5, 4712-4715, (2014).

18. Szafranski, M., Investigation of phase instabilities in guanidinium halogenoplumbates(II). Thermochimica Acta 307, 177-183, (1997).

19. Szafranski, M.; Katrusiak, A., Phase transitions in the layered structure of diguanidinium tetraiodoplumbate. Physical Review B, 61, 1026-1035, (2000).

20. Jeon, N. J. et. al. Solvent engineering for high-performance inorganic-organic hybrid perovskite solar cells. Nature Materials 13, 897-903, (2014).

21. Jodlowski, A. D. et. al. Benign-by-Design Solventless Mechanochemical Synthesis of Three-, Two-, and One-Dimensional Hybrid Perovskites. Angewandte Chemie International Edition 55, 14972-14977, (2016).

22. Huang, J. et. al. Sequential Introduction of Cations Deriving Large-Grain CsxFA1-xPbI3 Thin Film for Planar Hybrid Solar Cells: Insight into Phase-Segregation and Thermal-Healing Behavior. Small 13, 1603225, (2016).

23. Marco, N. D et. al. Guanidinium: A Route to Enhanced Carrier Lifetime and Open-Circuit Voltage in Hybrid Perovskite Solar Cells. Nano Letters 16, 1009-1016, (2016).

24. Buin, A et. al. Halide-Dependent Electronic Structure of Organolead Perovskite Materials. Chemistry of Materials 27, 4405-4412, (2015).

25. Nagabhushana, G. P. et. al. Direct calorimetric verification of thermodynamic instability of lead halide hybrid perovskites. Proceedings of the National Academy of Sciences 113, 7717-7721, (2016).

26. Quan, L. N. et. al. Ligand-Stabilized Reduced-Dimensionality Perovskites. Journal of the American Chemical Society 138, 2649-2655, (2016).

27. Lee, J. H. et. al. The nature of hydrogen-bonding interaction in the prototypic hybrid halide perovskite, tetragonal CH3NH3PbI3. Scientific Reports 6, 21687, (2016).

28. Domanski, K. et. al. Not All That Glitters Is Gold: Metal-Migration-Induced Degradation in Perovskite Solar Cells.

ACS Nano 10, 6306-6314, (2016).

29. Draguta, S. et. al. Spatially Non-uniform Trap State Densities in Solution-Processed Hybrid Perovskite Thin Films. The Journal of Physical Chemistry Letters 7, 715-721, (2016).

30. Grancini, G. et. al. The Impact of the Crystallization Processes on the Structural and Optical Properties of Hybrid Perovskite Films for Photovoltaics. The Journal of Physical Chemistry Letters 5, 3836-3842, (2014).

31. Quarti, C. et. al. The Raman Spectrum of the CH3NH3PbI3 Hybrid Perovskite: Interplay of Theory and Experiment. The Journal of Physical Chemistry Letters 5, 279-284, (2014).

32. Grancini, G. et. al. CH3NH3PbI3 perovskite single crystals: surface photophysics and their interaction with the environment. Chemical Science 6, 7305-7310, (2015).

33. Preda, N. et. al. Raman and Photoluminescence Studies on Intercalated Lead Iodide with Pyridine and Iodine. Journal of Optoelectronics and Advanced Materials, 10, 319-322, (2008).

34. Wyckoff, R. W. G., Crystal Structures. Second edition. Interscience Publishers, New York 1, 239-444, (1963).

35. Szafranski, M.; Jarek, M., Origin of spontaneous polarization and reconstructive phase transition in guanidinium iodide. CrystEngComm 15, 4617-4623, (2013).

36. Yamamuro, O. et. al. Neutron diffraction and calorimetric studies of methylammonium iodide. Acta Crystallographica, B48, 329-336, (1992).

37. Ishida, H et. al. EXAFS Study on the Phase-Transition (Phase-$\alpha$'-$\delta$) in CH3NH3I. Z. Naturforsch. A. 50, 876-880, (1995).

38. Stoumpos, C. C. et. al. Semiconducting Tin and Lead Iodide Perovskites with Organic Cations: Phase Transitions, High Mobilities, and Near-Infrared Photoluminescent Properties. Inorganic Chemistry 52, 9019-9038, (2013).

39. Motta, C. et. al. Revealing the role of organic cations in hybrid halide perovskite CH3NH3PbI3. Nature Communications 6, (2015).

40. Ong, K. P. et. al. Structural Evolution in Methylammonium Lead Iodide CH3NH3PbI3. The Journal of Physical Chemistry A 119, 11033-11038, (2015).

41. Perdew, J. P. et. al. Generalized Gradient Approximation Made Simple. Physical Review Letters 77, 3865-3868, (1996).

42. Monkhorst, H. J. et. al. Special points for Brillouin-zone integrations. Physical Review B 13, 5188-5192, (1976).

43. Lv, H. et. al. Density functional theory (DFT) investigation on the structure and electronic properties of the cubic perovskite PbTiO3. Applied Catalysis A: General 404, 54-58, (2011).

**Claims**

1. An optoelectronic device comprising an organic-inorganic perovskite comprising a guanidinium cation.

2. The optoelectronic device of claim 1, wherein said perovskite has a 3D crystal structure.

3. The optoelectronic device of any one of claims 1 or 2, which comprises two organic cations including said guanidinium cation.

4. The optoelectronic device of any one of claims 1-3, wherein said guanidinium provides > 0 mol.% and $\leq$ 30mol.% of the organic cations in said organic-inorganic perovskite.

5. The optoelectronic device of any one of claims 1-4, wherein said organic-inorganic perovskite further comprises metal cations and anions, said anions being preferably selected from one or more halogens.

6. The optoelectronic device of any one of the preceding claims, wherein said organic-inorganic perovskite has a formula selected from formula (I)-(IV) below:

$$G_X [C]_Y [M] [A]_4 \qquad (I)$$

$$G_X [C]_Z [M] [A]_3 \qquad (II)$$

$$G_X [C]_Z [N] [A]_4 \qquad (III)$$

$$G_X [B]_Z [M] [A]_4 \qquad (IV)$$

wherein,

G is guanidinium cation;

[C] is selected independently from one or several different organic and inorganic, monovalent cations, which may be the same or different, wherein said organic cations are selected independently from primary, secondary, tertiary or quaternary organic ammonium compounds, including N-containing heterorings and ring systems, said organic monovalent cations having from 1 to 10 carbons and 1 to 10 heteroatoms, and wherein said inorganic cations are selected, independently, from cations of elements of Group 1 of the periodic table;

[B] is one or several different organic, bivalent cations selected from primary, secondary, tertiary or quaternary organic ammonium compounds having from 1 to 15 carbons and 2 to 15 heteroatoms and having two positively charged nitrogen atoms;

[M] and [N] are one or several different metal cations,

[A] are one or several different anions,

X, Y and Z are selected so that:

$$X + Z = 1,$$

$$X + Y = 2,$$

$$0 < X \leq 0.5.$$

7. The optoelectronic device of claim 6, wherein

[M] is one or several different divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, $Eu^{2+}$, or $Yb^{2+}$;

[N] is selected from the group of $Bi^{3+}$ and $Sb^{3+}$; and

[A] are independently selected from $Cl^-$, $Br^-$, $I^-$, $NCS^-$, $CN^-$, and $NCO^-$, preferably halogen.

8. The optoelectronic device of any one of claims 1-7, wherein said organic-inorganic perovskite has a formula selected from formula (X) below:

$$G_X \, C^1_P \, C^2_Q \, C^3_R \, M \, A^1_2 \, A^2_X \, A^3_P \, A^4_Q \, A^5_R \qquad (X)$$

wherein,

M is a divalent metal cation selected from the group consisting of $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$ $Pb^{2+}$, $Eu^{2+}$, or $Yb^{2+}$;

G is said guanidinium cation;

$C^1$, $C^2$, $C^3$, may be the same or different and are independently selected from monovalent organic and inorganic cations, wherein said organic cations may be the same or different and are selected independently from primary, secondary, tertiary or quaternary organic ammonium compounds, including N-containing heterorings and ring systems, said organic cations having from 1 to 10 carbons and 1 to 10 heteroatoms, and wherein said inorganic cations may be the same or different and are independently selected from $Cs^+$, $Rb^+$, and $K^+$;

$A^1$, $A^2$, $A^3$, $A^4$, $A^5$ may be the same or different and are independently selected from $Cl^-$, $Br^-$, $I^-$, $NCS^-$, $CN^-$, and $NCO^-$;

X, P, Q R are selected so that:

$$0 < X \leq 0.5,$$

$$P > 0, Q \geq 0, R \geq 0,$$

and

$$X + P + Q + R \geq 1.$$

9. The optoelectronic device of claim 8, wherein said organic-inorganic perovskite has a formula selected from formula (XI) below:

$$G_X \, C^1_P \, M \, A^1_2 \, A^2_X \, A^3_P \qquad (XI)$$

wherein G, $C^1$, M, $A^1$, $A^2$, $A^3$, are as defined in claim 8,

$$0 < X \leq 0.5,$$

$$P > 0,$$

and

$$X + P \geq 1.$$

10. The optoelectronic device of any one of the preceding claims, wherein said organic-inorganic perovskite comprises one or more selected from the group consisting of: methyl ammonium, formamidinium, (protonated) 5-amino valeric acid, hydrazinium $[H_3N\text{-}NH_2]^+$, azetidinium $[(CH_2)_3NH_2]^+$, $Cs^+$, $Rb^+$, and $K^+$ and combinations comprising two or more of the aforementioned.

11. The optoelectronic device of any one of the preceding claims, which comprises:

  (i) a first electrode, and
  (ii) a second electrode,

wherein said organic-inorganic perovskite is disposed between said first and second electrode.

12. The optoelectronic device of claim 11, which further comprises one or more selected from an n-type layer and a p-type layer, disposed between said first and second electrode, said n- and/or p-type layer, in as far as present, preferably being in electric contact with said organic-inorganic perovskite.

13. The optoelectronic device of any one of the preceding claims, which is a photovoltaic device.

14. A method for preparing an optoelectronic device comprising: depositing a layer of an organic-inorganic perovskite comprising guanidinium, wherein said organic-inorganic perovskite layer is deposited by depositing a solution comprising all constituents of the organic-inorganic perovskite, preferably in a single step deposition process, or by sublimation.

15. The use of guanidinium in an optoelectronic device, preferably a photovoltaic device, preferably in an organic-inorganic perovskite layer of said optoelectronic device.

16. An organic-inorganic perovskite comprising two or more organic cations, one of said two or more organic cations being guanidinium, said perovskite having a 3D (three dimensional) crystal structure.

**Figure 1a**

**Figure 1b**

**Figure 1d**

**Figure 1c**

**Figure 1e**

**Figure 1f**

Figure 2a

Figure 2b

Figure 2c

**Figure 3a**

**Figure 3c**

**Figure 3d**

Figure 3b

Figure 3d

Figure 3e

Figure 4a

**Figure 4b**

**Figure 4c**

Europäisches
Patentamt

European
Patent Office

Office européen
des brevets

# EUROPEAN SEARCH REPORT

Application Number

EP 17 20 2649

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NICHOLAS DE MARCO ET AL: "Guanidinium: A Route to Enhanced Carrier Lifetime and Open-Circuit Voltage in Hybrid Perovskite Solar Cells", NANO LETTERS, vol. 16, no. 2, 20 January 2016 (2016-01-20), pages 1009-1016, XP055499702, US ISSN: 1530-6984, DOI: 10.1021/acs.nanolett.5b04060 * figures 2,S4 * -& Nicholas De Marco ET AL: "Guanidinium: A Route to Enhanced Carrier Lifetime and Open-Circuit Voltage in Hybrid Perovskite Solar Cells - Supporting Information", Nano Letters, 20 January 2016 (2016-01-20), pages 1009-1016, XP055499704, United States DOI: 10.1021/acs.nanolett.5b04060 Retrieved from the Internet: URL:https://pubs.acs.org/doi/suppl/10.1021/acs.nanolett.5b04060/suppl_file/nl5b04060_si_001.pdf [retrieved on 2018-08-14] ----- | 1-15 | INV. H01L51/46 |
| X | XIAOMENG HOU ET AL: "Effect of guanidinium on mesoscopic perovskite solar cells", JOURNAL OF MATERIALS CHEMISTRY A, vol. 5, no. 1, 1 January 2017 (2017-01-01), pages 73-78, XP055499660, GB ISSN: 2050-7488, DOI: 10.1039/C6TA08418D * the whole document * -/-- | 1-15 | TECHNICAL FIELDS SEARCHED (IPC)<br><br>H01L |

The present search report has been drawn up for all claims

| Place of search | Date of completion of the search | Examiner |
|---|---|---|
| Munich | 15 August 2018 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 17 20 2649

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| | -& Xiaomeng Hou ET AL: "Effect of guanidinium on mesoscopic perovskite solar cells - Electronic supplementary information", Journal of Materials Chemistry A. This journal is The Royal Society of Chemistry, 16 November 2016 (2016-11-16), pages 73-78, XP055499532, DOI: 10.1039/c6ta08418d Retrieved from the Internet: URL:http://www.rsc.org/suppdata/c6/ta/c6ta08418d/c6ta08418d1.pdf [retrieved on 2018-08-14] ----- | | |
| A | PABLO P. BOIX ET AL: "Perovskite Solar Cells: Beyond Methylammonium Lead Iodide", JOURNAL OF PHYSICAL CHEMISTRY LETTERS, vol. 6, no. 5, 13 February 2015 (2015-02-13), pages 898-907, XP055499653, US ISSN: 1948-7185, DOI: 10.1021/jz502547f * page 903 * ----- | 2 | |
| T | JODLOWSKI ALEXANDER D ET AL: "Large guanidinium cation mixed with methylammonium in lead iodide perovskites for 19% efficient solar cells", NATURE ENERGY, NATURE PUBLISHING GROUP UK, LONDON, vol. 2, no. 12, 8 December 2017 (2017-12-08), pages 972-979, XP036429296, DOI: 10.1038/S41560-017-0054-3 [retrieved on 2017-12-08] * the whole document * ----- | | TECHNICAL FIELDS SEARCHED (IPC) |

The present search report has been drawn up for all claims

| Place of search | Date of completion of the search | Examiner |
|---|---|---|
| Munich | 15 August 2018 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2014180780 A
- EP 2850626 B1
- US 20170162811 A
- EP 2850626 A
- EP 3065189 A
- EP 2846371 A
- EP 2804232 A

### Non-patent literature cited in the description

- **RONG et al.** *J. Phys. Chem. Lett.,* 2014, vol. 5, 2160-2164
- **ANYI MEI et al.** *Science,* 2014, vol. 345, 295
- **DE WOLF, S.** Organometallic Halide Perovskites: Sharp Optical Absorption Edge and Its Relation to Photovoltaic Performance. *Journal of Physical Chemistry Letters,* 2014, vol. 5, 1035-1039
- **STRANKS, S. D.** Electron-Hole Diffusion Lengths Exceeding 1 Micrometer in an Organometal Trihalide Perovskite Absorber. *Science,* 2013, vol. 342, 341-344
- **XING, G.** Long-Range Balanced Electron- and Hole-Transport Lengths in Organic-Inorganic CH3NH3PbI3. *Science,* 2013, vol. 342, 344-347
- **SHI, D.** Low trap-state density and long carrier diffusion in organolead trihalide perovskite single crystals. *Science,* 2015, vol. 347, 519-522
- **ZHANG, Y.** Optimization of Stable Quasi-Cubic FAxMA1-xPbI3 Perovskite Structure for Solar Cells with Efficiency beyond 20%. *ACS Energy Letters,* 2017, vol. 2, 802-806
- **BI, D.** Efficient luminescent solar cells based on tailored mixed-cation perovskites. *Science Advances,* 2016, vol. 2, 1
- **CONINGS, B.** Intrinsic Thermal Instability of Methylammonium Lead Trihalide Perovskite. *Advanced Energy Materials,* 2015, vol. 5, 1500477
- **GRATIA, P.** Intrinsic Halide Segregation at Nanometer Scale Determines the High Efficiency of Mixed Cation/Mixed Halide Perovskite Solar Cells. *Journal of the American Chemical Society,* 2016, vol. 138, 15821-15824
- **HOKE, E. T.** Reversible photo-induced trap formation in mixed-halide hybrid perovskites for photovoltaics. *Chemical Science,* 2015, vol. 6, 613-617
- **LI, X.** Improved performance and stability of perovskite solar cells by crystal crosslinking with alkylphosphonic acid ω-ammonium chlorides. *Nat Chem.,* 2015, vol. 7, 703-711
- **YOU, J.** Improved air stability of perovskite solar cells via solution-processed metal oxide transport layers. *Nat Nano,* 2016, vol. 11, 75-81
- **KALTENBRUNNER, M.** Flexible high power-per-weight perovskite solar cells with chromium oxide-metal contacts for improved stability in air. *Nat Mater,* 2015, vol. 14, 1032-1039
- **TSAI, H.** High-efficiency two-dimensional Ruddlesden-Popper perovskite solar cells. *Nature,* 2016, vol. 536, 312-316
- **SALIBA, M.** Cesium-containing triple cation perovskite solar cells: improved stability, reproducibility and high efficiency. *Energy & Environmental Science,* 2016, vol. 9, 1989-1997
- **SALIBA, M.** Incorporation of rubidium cations into perovskite solar cells improves photovoltaic performance. *Science,* 2016, vol. 354, 206-209
- **GOLDSCHMIDT, V. M.** Die Gesetze der Krystallochemie. *Naturwissenschaften,* 1926, vol. 14, 477-485
- **KIESLICH, G.** Solid-state principles applied to organic-inorganic perovskites: new tricks for an old dog. *Chemical Science,* 2014, vol. 5, 4712-4715
- **SZAFRANSKI, M.** Investigation of phase instabilities in guanidinium halogenoplumbates(II). *Thermochimica Acta,* 1997, vol. 307, 177-183
- **SZAFRANSKI, M. ; KATRUSIAK, A.** Phase transitions in the layered structure of diguanidinium tetraiodoplumbate. *Physical Review B,* 2000, vol. 61, 1026-1035
- **JEON, N. J.** Solvent engineering for high-performance inorganic-organic hybrid perovskite solar cells. *Nature Materials,* 2014, vol. 13, 897-903
- **JODLOWSKI, A. D.** Benign-by-Design Solventless Mechanochemical Synthesis of Three-, Two-, and One-Dimensional Hybrid Perovskites. *Angewandte Chemie International Edition,* 2016, vol. 55, 14972-14977

- **HUANG, J.** Sequential Introduction of Cations Deriving Large-Grain CsxFA1-xPbI3 Thin Film for Planar Hybrid Solar Cells: Insight into Phase-Segregation and Thermal-Healing Behavior. *Small,* 2016, vol. 13, 1603225
- **MARCO, N. D.** Guanidinium: A Route to Enhanced Carrier Lifetime and Open-Circuit Voltage in Hybrid Perovskite Solar Cells. *Nano Letters,* 2016, vol. 16, 1009-1016
- **BUIN, A.** Halide-Dependent Electronic Structure of Organolead Perovskite Materials. *Chemistry of Materials,* 2015, vol. 27, 4405-4412
- **NAGABHUSHANA, G. P.** Direct calorimetric verification of thermodynamic instability of lead halide hybrid perovskites. *Proceedings of the National Academy of Sciences,* 2016, vol. 113, 7717-7721
- **QUAN, L. N.** Ligand-Stabilized Reduced-Dimensionality Perovskites. *Journal of the American Chemical Society,* 2016, vol. 138, 2649-2655
- **LEE, J. H.** The nature of hydrogen-bonding interaction in the prototypic hybrid halide perovskite, tetragonal CH3NH3PbI. *Scientific Reports,* 2016, vol. 6, 21687
- **DOMANSKI, K.** Not All That Glitters Is Gold: Metal-Migration-Induced Degradation in Perovskite Solar Cells. *ACS Nano,* 2016, vol. 10, 6306-6314
- **DRAGUTA, S.** Spatially Non-uniform Trap State Densities in Solution-Processed Hybrid Perovskite Thin Films. *The Journal of Physical Chemistry Letters,* 2016, vol. 7, 715-721
- **GRANCINI, G.** The Impact of the Crystallization Processes on the Structural and Optical Properties of Hybrid Perovskite Films for Photovoltaics. *The Journal of Physical Chemistry Letters,* 2014, vol. 5, 3836-3842
- **QUARTI, C.** The Raman Spectrum of the CH3NH3PbI3 Hybrid Perovskite: Interplay of Theory and Experiment. *The Journal of Physical Chemistry Letters,* 2014, vol. 5, 279-284
- **GRANCINI, G.** CH3NH3PbI3 perovskite single crystals: surface photophysics and their interaction with the environment. *Chemical Science,* 2015, vol. 6, 7305-7310
- **PREDA, N.** Raman and Photoluminescence Studies on Intercalated Lead Iodide with Pyridine and Iodine. *Journal of Optoelectronics and Advanced Materials,* 2008, vol. 10, 319-322
- **WYCKOFF, R. W. G.** Crystal Structures. Interscience Publishers, 1963, vol. 1, 239-444
- **SZAFRANSKI, M. ; JAREK, M.** Origin of spontaneous polarization and reconstructive phase transition in guanidinium iodide. *CrystEngComm,* 2013, vol. 15, 4617-4623
- **YAMAMURO, O.** Neutron diffraction and calorimetric studies of methylammonium iodide. *Acta Crystallographica,* 1992, vol. B48, 329-336
- **ISHIDA, H.** EXAFS Study on the Phase-Transition (Phase-$\alpha$'-$\delta$) in CH3NH3I. Z. *Naturforsch. A.,* 1995, vol. 50, 876-880
- **STOUMPOS, C. C.** Semiconducting Tin and Lead Iodide Perovskites with Organic Cations: Phase Transitions, High Mobilities, and Near-Infrared Photoluminescent Properties. *Inorganic Chemistry,* 2013, vol. 52, 9019-9038
- **MOTTA, C.** Revealing the role of organic cations in hybrid halide perovskite CH3NH3PbI. *Nature Communications,* 2015, vol. 6
- **ONG, K. P.** Structural Evolution in Methylammonium Lead Iodide CH3NH3PbI. *The Journal of Physical Chemistry A,* 2015, vol. 119, 11033-11038
- **PERDEW, J. P.** Generalized Gradient Approximation Made Simple. *Physical Review Letters,* 1996, vol. 77, 3865-3868
- **MONKHORST, H. J.** Special points for Brillouin-zone integrations. *Physical Review B,* 1976, vol. 13, 5188-5192
- **LV, H.** Density functional theory (DFT) investigation on the structure and electronic properties of the cubic perovskite PbTiO3. *Applied Catalysis A: General,* 2011, vol. 404, 54-58